# EUROPÄISCHE PATENTSCHRIFT

(11) **EP 3 226 064 B1**
(45) Veröffentlichungstag und Bekanntmachung des Hinweises auf die Patenterteilung: **24.10.2018**
(21) Anmeldenummer: 16163113.0
(22) Anmeldetag: 31.03.2016
(51) Int. Cl.: G02B 27/10

(54) **VORRICHTUNG UND VERFAHREN ZUR ERZEUGUNG EINES LICHTSTRAHLS**
DEVICE AND METHOD FOR CREATING A LIGHT BEAM
DISPOSITIF ET PROCÉDÉ DESTINÉS À LA PRODUCTION D'UN RAYON LUMINEUX

(43) Veröffentlichungstag der Anmeldung: 04.10.2017
(73) Patentinhaber: Fisba AG, 9016 St. Gallen (CH)
(72) Erfinder: Moser, Hansruedi, 9452 Hinterforst (CH); Jäger, Eberhard, 82152 Krailling (DE)
(74) Vertreter: Hepp Wenger Ryffel AG

(56) Entgegenhaltungen:
- WO-A1-2015/134842
- DE-A1-102013 216 896
- US-A1- 2006 238 660

## Beschreibung

Die Erfindung betrifft eine Vorrichtung und ein Verfahren zur Erzeugung eines Lichtstrahls gemäss dem Oberbegriff der unabhängigen Ansprüche.

Es sind bereits Lichtmodule bekannt, bei denen Licht unterschiedlicher Wellenlängen in einem Strahl kombiniert wird und dann auf eine Projektionsfläche gelenkt wird.

Aus der DE 10 2013 216896 ist beispielsweise ein Projektionsmodul bekannt, in welchem Lichtquellen verschiedener Wellenlängen auf je einen wellenlängensensitiven, zum Beispiel einen dielektrischen, bzw. dichroitischen, Spiegel gerichtet werden, wobei das emittierte Licht aus den Lichtquellen durch die Spiegel in einen gemeinsamen Strahl eingekoppelt wird. Der kombinierte Strahl kann zum Beispiel auf einen MEMS-Spiegel geführt werden, welcher den Lichtstrahl dann auf eine Projektionsoberfläche lenkt.

Für viele Anwendungen wird eine hohe Leistung in einem kollimierten Strahl gefordert. Da die Leistungen handelsüblicher Dioden limitiert sind, wird eine Erhöhung der Leistung durch eine Verdoppelung der Anzahl Laserdioden realisiert.

Damit die Strahlen zweier Lichtquellen mit einem Filter übereinander gelegt werden können und eine Verdoppelung der Leistung erreicht werden kann, müssen die Polarisationsrichtungen senkrecht zueinander stehen. Die Polarisation kann zum Beispiel mit einer A/2-Verzögerungsplatte gedreht werden. Verzögerungsplatten sind allerdings hochempfindliche und teure Bauteile.

Alternativ kann die Lichtquelle gedreht eingebaut werden. Das Licht von Laserdioden weist allerdings in der Regel ein asymmetrisches Strahlprofil auf. Wird Halbleiterlaserlicht mit senkrecht zueinanderstehenden Polarisationen überlagert, verlaufen die Halbachsen des ellipsenförmigen Strahlprofils, bzw. Strahlquerschnitts ebenfalls senkrecht zueinander, wodurch die Strahlbreite des gemeinsamen Strahls aus der Überlagerung des Lichts aus unterschiedlichen Lichtquellen insgesamt vergrössert wird.

Die DE 10 2013 216896 schlägt daher vor, dass das Licht aus einer ersten roten Lichtquelle eine andere Wellenlänge aufweist, als das Licht der zweiten roten Lichtquelle. Für die Überlagerung von Licht der ersten und der zweiten Lichtquelle kann anstelle eines Polarisationsstrahlteilers ein dielektrischer Spiegel verwendet werden, ohne dass das Strahlprofil vergrössert und das Auflösungsvermögen reduziert wird.

Der Aufbau hat allerdings den Nachteil, dass nicht auf herkömmliche oder handelsübliche Dioden zurückgegriffen werden kann und dass tatsächlich eine Überlagerung von Lichtstrahlen mit vier verschiedenen Wellenlängenbereichen stattfindet. Eine Ansteuerung der Lichtquellen, wie sie bei bekannten RGB Modulen üblich ist, kann nicht ohne Weiteres vorgenommen werden.

Es ist daher die Aufgabe der Erfindung, eine Vorrichtung zur Erzeugung eines Lichtstrahls sowie ein Verfahren zur Erzeugung eines Lichtstrahls zu schaffen, welche die Nachteile des Standes der Technik vermeiden. Insbesondere ist es Aufgabe der Erfindung, eine Vorrichtung und ein Verfahren zu schaffen, welche einfache Komponenten nutzen und kostengünstig bereitstellbar sind.

Die Aufgabe wird gelöst durch eine Vorrichtung zur Erzeugung eines Lichtstrahls mit wenigstens einer ersten und einer zweiten Lichtquelle, wobei die erste und die zweite Lichtquelle im Betrieb bevorzugt Licht der gleichen Wellenlänge emittieren. Die Lichtquellen sind erfindungsgemäss derart zueinander angeordnet, dass das Strahlprofil der ersten Lichtquelle gegenüber dem Strahlprofil der zweiten Lichtquelle um einen Drehwinkel, bevorzugt um 90 Grad, um eine Achse in Richtung der Lichtausbreitung gedreht ist.

Wenigstens einer der Lichtquellen ist ein Strahldrehelement nachgeordnet, das eine Drehung des Strahlprofils um einen Winkel derart bewirkt, dass das Strahlprofil der Lichtquelle nach Durchlaufen des Strahldrehelements in einer Ebene senkrecht zur Ausbreitungsrichtung des Lichts im Wesentlichen gleich ausgerichtet ist, wie das Strahlprofil der anderen Lichtquelle in der Ebene senkrecht zur Ausbreitungsrichtung.

Insbesondere bewirkt das Strahldrehelement, dass nach Durchlaufen des Strahldrehelements die Hauptachsen der Strahlprofile parallel zueinander ausgerichtet sind.

Bei den Lichtquellen handelt es sich insbesondere um Laserdioden, die bevorzugt rotes Licht emittieren.

Das Strahldrehelement bewirkt eine Ausrichtung des Strahlprofils.

Lichtquellen mit asymmetrischen Strahlprofilen können beliebig zueinander ausgerichtet werden und durch das Strahldrehelement können dennoch parallele Strahlprofile erreicht werden.

Mit dem Strahldrehelement wird insbesondere nicht die Polarisation des emittierten Strahls gedreht. Das Strahldrehelement bietet also eine Möglichkeit, das Strahlprofil unabhängig von der Polarisation zu verändern.

In einer bevorzugten Ausführung der Erfindung umfasst die Vorrichtung weitere Lichtquellen, bevorzugt zwei weitere Lichtquellen, die im Betrieb Licht emittieren mit Wellenlängen, welche jeweils unterschiedlich sind zu den Wellenlängen der ersten und zweiten Lichtquelle. Auf diese Weise kann ein Lichtmodul zur Verfügung gestellt werden, das beispielsweise in einem Pico-Projektor zur Bilddarstellung im sichtbaren Wellenlängenbereich zum Einsatz kommen kann.

Die Vorrichtung ist vorzugsweise so ausgeführt, dass Strahlführungselemente vorgesehen sind, insbesondere, um die Lichtstrahlen zusammenzuführen, die von verschiedenen Lichtquellen erzeugt werden.

Die Lichtquellen und das wenigstens eine Strahldrehelement sind bevorzugt so angeordnet, dass Lichtstrahlen mit gleich ausgerichteten Strahlprofilen kombiniert werden.

Bevorzugt sind Lichtquellen vorgesehen, die im Betrieb jeweils polarisiertes Licht, bevorzugt linear polarisiertes Licht, emittieren. Dabei sind die Polarisationsrichtungen der ersten und zweiten Lichtquelle entsprechend den Strahlprofilen gegeneinander gedreht und das Strahldrehelement bewirkt nicht die Drehung der Polarisation.

Typischerweise sind die Strahlprofile von Laserdioden in Richtung der Slow- und in Fast Axis unterschiedlich, sodass sich in einer Ebene senkrecht zur Ausbreitungsrichtung des Lichts elliptische Strahlprofile ergeben. Wird die Lichtquelle um eine Achse in Ausbreitungsrichtung gedreht, so ändert sich nicht nur die Polarisation, sondern auch die Ausrichtung des Strahlprofils.

Mit dem Strahldrehelement lassen sich Strahlen gleicher Wellenlänge und unterschiedlicher Polarisation mit gleichem Strahlprofil zur Verfügung stellen. Die Strahlen können dann zum Beispiel über einen Polteiler kombiniert werden, ohne dass dabei das Strahlprofil vergrössert und das Auflösungsvermögen reduziert wird.

In einer vorteilhaften Ausführung der Erfindung ist jeder Lichtquelle eine Kollimierungslinse zum Kollimieren eines Lichtstrahls, der aus der Lichtquelle austritt, zugeordnet.

Vorteilhafterweise umfassen die Strahlführungselemente einen Polteiler. Mit dem Polteiler können Lichtstrahlen gleicher Wellenlänge aber unterschiedlicher Polarisation zusammengeführt werden. Der Polteiler reflektiert Licht mit einer bestimmten Polarisationsrichtung und ist durchlässig für Licht, das in anderen Richtungen polarisiert ist.

Vorteilhafterweise umfassen die Strahlführungselemente einen wellenlängensensitiven Spiegel, zum Beispiel einen dichroitischen Spiegel. Der Spiegel ist beispielsweise für bestimmte Wellenlängen reflektierend und für andere Wellenlängen durchlässig. Mittels solcher Filter können in einen Lichtstrahl mit bestimmten Wellenlängen Strahlen mit weiteren Wellenlängen eingekoppelt werden.

Bevorzugt umfasst die Vorrichtung Polteiler und dichroitische Spiegel, sodass Lichtstrahlen gleicher Wellenläge miteinander kombiniert werden können und in diesen kombinierten Lichtstrahl Lichtstrahlen mit weiteren Wellenlängen einkoppelbar sind. Es kann so eine Lichtstrahl mit roten, grünen und blauen Wellenlängenkomponenten erhalten werden, wobei die roten Komponenten von mehreren Lichtquellen gespeist sind.

In einer vorteilhaften Ausführung umfassen die Stahlführungselemente ein Prismenteleskop. Das Prismenteleskop dient zum Umformen des Strahlquerschnitts, wobei zum Beispiel ein Laserstrahl mit elliptischem Querschnitt, wie er typischerweise eine Kollimiervorrichtung verlässt, durch ein Prismenpaar in einen Strahl mit rundem Querschnitt transformiert wird.

Bevorzugt wird ein kombinierter Lichtstrahl durch das Prismenteleskop geführt.

Als Strahldrehelement kann ein Zylinderteleskop vorgesehen sein. Dieses ist bevorzugt so angeordnet, dass dessen Zylinderachse den Drehwinkel zwischen den Lichtquellen teilt.

Mit dem Drehwinkel zwischen zwei Lichtquellen ist der Winkel gemeint, um den eine Lichtquelle bezüglich der Ausbreitungsrichtung des Lichts gegenüber einer anderen Lichtquelle gedreht ist. Bei Lichtquellen mit gleicher Austrahlcharakteristik, die ein elliptisches Strahlprofil aufweisen, beschreibt der Drehwinkel den Winkel zwischen den Hauptachsen der jeweiligen Ellipsen. Bei Lichtquellen, die polarisiertes Licht abgeben, beschreibt der Drehwinkel den Winkel zwischen den jeweiligen Hauptpolarisationsrichtungen, zum Beispiel den Winkel zwischen den jeweiligen Fast- und Slow Achsen.

Ist das Zylinderteleskop so angeordnet, dass die Zylinderachse den Drehwinkel halbiert, so wird das Strahlprofil wieder um den Drehwinkel zurückgedreht.

Insbesondere ist die Zylinderachse um 45 Grad gegenüber einer Hauptachse des Strahlprofils der Lichtquelle geneigt.

Bei zwei Lichtquellen, von denen die eine um 90 Grad um die Achse der Ausbreitungsrichtung gegenüber der anderen Lichtquelle gedreht ist, damit zum Beispiel zwei Lichtstrahlen mit senkrecht zueinander stehender Polarisation erzeugt werden, kann ein so angeordnetes Zylinderteleskop die Strahlprofile wieder in parallele Ausrichtung bringen, wobei die Polarisation unbeeinflusst bleibt.

Die Lichtquellen können in einer Ebene, bevorzugt nebeneinander, weiter bevorzugt mit in etwa paralleler Lichtausbreitungsrichtung, angeordnet sein. Die Lichtquellen lassen sich dann auf einem gemeinsamen Träger anordnen, was die spätere Montage erleichtert. Jeder Lichtquelle ist ein entsprechender Spiegel zum Zusammenführen der Lichtstrahlen zugeordnet, die ebenfalls nebeneinander angeordnet werden können.

Die der Erfindung zugrundeliegende Aufgabe wird weiterhin gelöst durch ein Verfahren zur Erzeugung eines Lichtstrahls, wobei wenigstens zwei Lichtquellen Licht, bevorzugt der gleichen Wellenlänge, emittieren. Dabei ist das Strahlprofil des von der ersten Lichtquelle emittierten Lichtstrahls gegenüber dem Strahlprofil des von der zweiten Lichtquelle emittierten Lichtstrahls um einen Drehwinkel, bevorzugt 90 Grad, gedreht. Wenigstens einer der Lichtstrahlen wird durch eine Strahldrehelement geführt. Das Strahlprofil des Lichtstrahls wird dabei derart um einen Winkel gedreht, dass das Strahlprofil der Lichtquelle nach Durchlaufen des Strahldrehelements in einer Ebene senkrecht zur Ausbreitungsrichtung des Lichts im Wesentlichen gleich ausgerichtet ist, wie das Strahlprofil der anderen Lichtquelle in der Ebene senkrecht zur Ausbreitungsrichtung.

Insbesondere sind die Hauptachsen der Strahlprofile parallel zueinander, nachdem der eine Lichtstrahl das Strahldrehelement durchlaufen hat.

In einer vorzugsweisen Weiterbildung emittieren weitere, bevorzugt zwei, Lichtquellen Licht, deren Wellenlängen jeweils unterschiedlich zu den Wellenlängen der ersten und zweiten Lichtquelle sind.

Besonders bevorzugt wird Licht von vier Lichtquellen in insgesamt drei unterschiedlichen Wellenlängenbereichen emittiert.

Vorzugsweise emittieren die Lichtquellen jeweils polarisiertes Licht, bevorzugt linear polarisiertes Licht. Dabei sind die Polarisationsrichtungen der ersten und zweiten Lichtquelle entsprechend den Strahlprofilen gegeneinander gedreht. Das Strahldrehelement sorgt nur für eine Drehung der Strahlprofile und bewirkt nicht die Drehung der Polarisation.

Vorteilhafterweise werden die Strahlen durch Strahlführungselemente zu einem kombinierten Strahl zusammengeführt. Die Strahlfügungselemente umfassen insbesondere einen Polteiler, einen wellenlängensensitiven, zum Beispiel einen dichroitischen, Spiegel.

Die Strahlen können durch ein Prismenteleskop geführt werden. Dort wird das Strahlprofil verändert, beispielweise ein elliptisches Strahlprofil in ein rundes Strahlprofile überführt.

Bevorzugt werden die Lichtstrahlen jeweils mit einer Kollimierlinse kollimiert.

Im Folgenden wird die Erfindung in Ausführungsbeispielen näher erläutert. Hierbei zeigen
- Fig. 1: eine schematische Ansicht einer erfindungsgemässen Vorrichtung in Draufsicht;
- Fig. 2a: eine schematische Ansicht der Strahlprofile zwei Lichtquellen vor Durchlaufen des Strahldrehelements;
- Fig. 2b: eine schematische Ansicht der Strahlprofile zwei Lichtquellen nach Durchlaufen des Strahldrehelements.

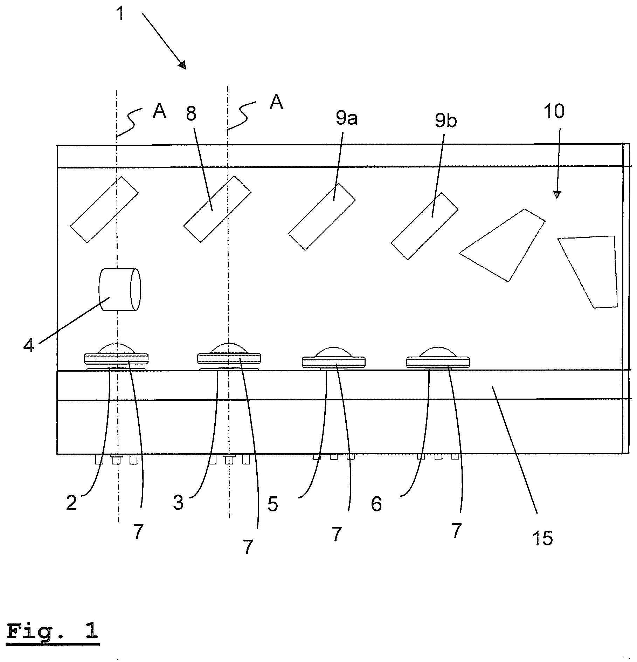

Figur 1 zeigt eine schematische Ansicht einer erfindungsgemässen Vorrichtung 1 in Draufsicht.

Die Vorrichtung umfasst eine erste Lichtquelle 2 und eine zweite Lichtquelle 3, hier in Form von Laserdioden, wobei die erste und die zweite Lichtquelle 2, 3 im Betrieb Licht der gleichen Wellenlänge emittieren, in diesem Fall Licht im roten Wellenlängenbereich.

Die Lichtquellen 2, 3 sind derart zueinander angeordnet, dass das Strahlprofil der ersten Lichtquelle 2 gegenüber dem Strahlprofil der zweiten Lichtquelle 3 um einen Drehwinkel D, bevorzugt um 90 Grad, um eine Achse A in Richtung der Lichtausbreitung gedreht ist.

Der ersten Lichtquelle 2 ist ein Strahldrehelement 4 nachgeordnet ist, das eine Drehung des Strahlprofils der ersten Lichtquelle um einen Winkel -D bewirkt.

Die Vorrichtung 1 umfasst zwei weitere Lichtquellen 5, 6, die im Betrieb Licht emittieren mit Wellenlängen, welche jeweils unterschiedlich sind zu den Wellenlängen der ersten und zweiten Lichtquelle 2, 3. Die weiteren Lichtquellen 5, 6 emittieren Licht im grünen und blauen Wellenlängenbereich.

Jeder Lichtquelle 2, 3, 5, 6 ist eine Kollimierungslinse 7 zum Kollimieren eines Lichtstrahls, der aus der Lichtquelle 2, 3, 5, 6 austritt, zugeordnet.

Die Vorrichtung umfasst Strahlungsführelemente 8, 9a, 9b zum Zusammenführen der Lichtstrahlen. Ein Strahlführelement ist als Polteiler 8 ausgeführt. Der Polteiler führt Lichtstrahlen gleicher Wellenlänge aber unterschiedlicher Polarisation zusammen.

Zwei Strahlführelemente sind als dichroitische Spiegel 9a, 9b ausgeführt. Sie sind reflektierend für einen bestimmten Wellenlängenbereich und leiten die anderen Wellenlängen durch. Mit den dichroitischen Spiegeln 9a, 9b werden Lichtstahlen unterschiedlicher Wellenlängen zusammengeführt.

Die Vorrichtung umfasst des Weiteren ein Prismenteleskop 10. Dieses führt den elliptischen Strahlquerschnitt des zusammengeführten Lichtstrahls in einen runden Strahlquerschnitt über.

Die Lichtquellen sind auf einem Diodenträger 15 in einer gemeinsamen Ebene angeordnet.

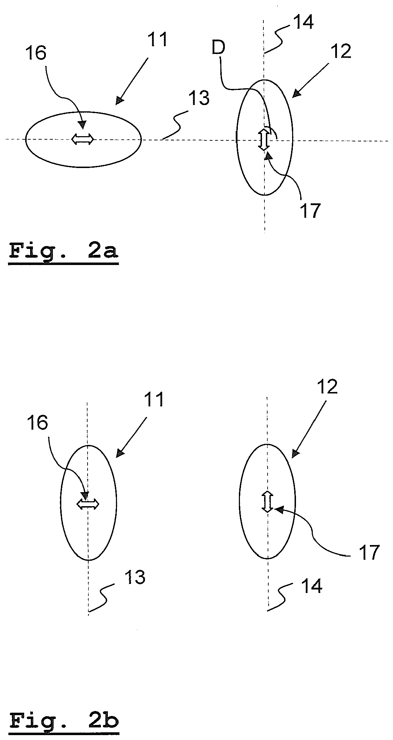

Figur 2a zeigt eine schematische Ansicht der Strahlprofile 11, 12 zwei Lichtquellen vor Durchlaufen des Strahldrehelements 4, Figur 2b die Strahlprofile nach Durchlaufen des Strahldrehelements 4.

Die erste Lichtquelle 2 ist um die Achse A in Ausbreitungsrichtung des Lichts um einen Drehwinkel D gedreht, im vorliegenden Fall 90 Grad. Damit schliessen nicht nur die Hauptpolarisationsrichtungen 16, 17 der Lichtquellen einen Winkel von 90 Grad ein, sondern auch die Ausrichtungen der Strahlprofile 11, 12. Im vorliegenden Fall haben die Strahlprofile 11, 12, eine elliptische Form, sodass die Ausrichtungen 13, 14 der langen Hauptachsen der Ellipsenprofile 11, 12 den Drehwinkel D einschliessen.

Nach Durchlaufen des Strahldrehelements 4 ist das Strahlprofil 11 der ersten Lichtquelle 2 in einer Ebene senkrecht zur Ausbreitungsrichtung A des Lichts im Wesentlichen gleich ausgerichtet, wie das Strahlprofil 12 der zweiten Lichtquelle 3 in der Ebene senkrecht zur Ausbreitungsrichtung.

Die Ausrichtungen 13, 14 der langen Hauptachsen der Strahlprofile 11, 12 sind parallel zueinander. Gleichzeitig steht die Hauptpolarisationsrichtung 16 der ersten Lichtquelle immer noch senkrecht zu der Hauptpolarisationsrichtung 17 der zweiten Lichtquelle. Die Lichtstrahlen lassen sich daher mit einem Polteiler zu einem Lichtstrahl kombinieren, wobei das Strahlprofil erhalten bleibt und nicht vergrössert wird.

## Patentansprüche

1. Vorrichtung zur Erzeugung eines Lichtstrahls mit wenigstens einer ersten und einer zweiten Lichtquelle (2, 3), insbesondere Laserdioden, wobei die erste und die zweite Lichtquelle (2, 3) im Betrieb bevorzugt Licht der gleichen Wellenlänge emittieren, **dadurch gekennzeichnet, dass** die Lichtquellen (2, 3) derart zueinander angeordnet sind, dass das Strahlprofil (11) der ersten Lichtquelle (2) gegenüber dem Strahlprofil (12) der zweiten Lichtquelle (3) um einen Drehwinkel (D), bevorzugt um 90 Grad, um eine Achse (A) in Richtung der Lichtausbreitung gedreht ist, und wenigstens einer der Lichtquellen (2, 3) ein Strahldrehelement (4) nachgeordnet ist, das eine Drehung des Strahlprofils um einen Winkel derart bewirkt, dass das Strahlprofil (11, 12) der Lichtquelle (2, 3) nach Durchlaufen des Strahldrehelements (4) in einer Ebene senkrecht zur Ausbreitungsrichtung (A) des Lichts im Wesentlichen gleich ausgerichtet ist, wie das Strahlprofil (11, 12) der anderen Lichtquelle (2, 3) in der Ebene senkrecht zur Ausbreitungsrichtung, dass insbesondere die Richtungen (13, 14) der Hauptachsen der Strahlprofile (11, 12) parallel zueinander sind.

2. Vorrichtung gemäss Anspruch 1, **dadurch gekennzeichnet, dass** die Vorrichtung weitere Lichtquellen (5, 6) umfasst, bevorzugt zwei weitere Lichtquellen (5, 6), die im Betrieb Licht emittieren mit Wellenlängen, welche jeweils unterschiedlich sind zu den Wellenlängen der ersten und zweiten Lichtquellen (2, 3).

3. Vorrichtung gemäss einem der Ansprüche 1 oder 2, **dadurch gekennzeichnet, dass**
Strahlführungselemente (8, 9a, 9b, 10) vorgesehen sind, insbesondere, um die Lichtstrahlen zusammenzuführen.

4. Vorrichtung nach einem der vorhergehenden Ansprüche, **dadurch gekennzeichnet, dass**
Lichtquellen (2, 3, 5, 6) vorgesehen sind, die im Betrieb jeweils polarisiertes Licht, bevorzugt linear polarisiertes Licht, emittieren, wobei die Polarisationsrichtungen der ersten und zweiten Lichtquelle (2, 3) entsprechend den Strahlprofilen (11, 12) gegeneinander gedreht sind, und das Strahldrehelement (4) nicht die Drehung der Polarisation bewirkt.

5. Vorrichtung nach einem der vorhergehenden Ansprüche, **dadurch gekennzeichnet, dass** jeder Lichtquelle (2, 3, 5, 6) eine Kollimierungslinse (7) zum Kollimieren eines Lichtstrahls, der aus der Lichtquelle (2, 3, 5, 6) austritt, zugeordnet ist.

6. Vorrichtung nach einem der Ansprüche 3 bis 5, **dadurch gekennzeichnet, dass** die Strahlführungselemente (8, 9a, 9b, 10) einen Polteiler (8) umfassen.

7. Vorrichtung nach einem der Ansprüche 3 bis 6, **dadurch gekennzeichnet, dass** die Strahlführungselemente (8, 9a, 9b, 10) dichroitische Spiegel (9a, 9b) umfassen.

8. Vorrichtung nach einem der Ansprüche 3 bis 7, **dadurch gekennzeichnet, dass** die Stahlführungselemente (8, 9a, 9b, 10) ein Prismenteleskop (10) umfassen.

9. Vorrichtung nach einem der vorhergehenden Ansprüche, **dadurch gekennzeichnet, dass** als Strahldrehelement (4) ein Zylinderteleskop vorgesehen ist, das so angeordnet ist, dass dessen Zylinderachse den Drehwinkel zwischen den Lichtquellen teilt, die Zylinderachse insbesondere um 45 Grad gegenüber einer Hauptachse des Strahlprofils der Lichtquelle geneigt ist.

10. Vorrichtung nach einem der vorhergehenden Ansprüche, **dadurch gekennzeichnet, dass** die Lichtquellen (2, 3, 5, 6) in einer Ebene, bevorzugt nebeneinander, weiter bevorzugt mit in etwa paralleler Lichtausbreitungsrichtung, angeordnet sind.

11. Verfahren zur Erzeugung eines Lichtstrahls, **dadurch gekennzeichnet, dass** wenigstens zwei Lichtquellen (2, 3) Licht, bevorzugt der gleichen Wellenlänge, emittieren, wobei das Strahlprofil (11) des von der ersten Lichtquelle (2) emittierten Lichtstrahls gegenüber dem Strahlprofil (12) des von der zweiten Lichtquelle (3) emittierten Lichtstrahls um einen Drehwinkel (D), bevorzugt 90 Grad, gedreht ist und wenigstens einer der Lichtstrahlen durch eine Strahldrehelement (4) geführt wird, wobei das Strahlprofil (11) des Lichtstrahls derart um einen Winkel gedreht wird, dass das Strahlprofil (11) der Lichtquelle (2) nach Durchlaufen des Strahldrehelements (4) in einer Ebene senkrecht zur Ausbreitungsrichtung (A) des Lichts im Wesentlichen gleich ausgerichtet ist, wie das Strahlprofil (12) der anderen Lichtquelle (3) in der Ebene senkrecht zur Ausbreitungsrichtung (A), dass insbesondere die Richtungen (13, 14) der Hauptachsen der Strahlprofile (11, 12) parallel zueinander sind.

12. Verfahren gemäss Anspruch 11, **dadurch gekennzeichnet, dass,** bevorzugt zwei, weitere Lichtquellen (5, 6) Licht emittieren, deren Wellenlängen jeweils unterschiedlich zu den Wellenlängen der ersten und zweiten Lichtquelle (2, 3) sind.

13. Verfahren gemäss Anspruch 11 oder 12, **dadurch gekennzeichnet, dass** die Lichtquellen (2, 3, 5, 6) jeweils polarisiertes Licht, bevorzugt linear polarisiertes Licht, emittieren, wobei die Polarisationsrichtungen der ersten und zweiten Lichtquelle (2, 3) entsprechend den Strahlprofilen (11, 12) gegeneinander gedreht sind, und das Strahldrehelement (4) nicht die Drehung der Polarisation bewirkt.

14. Verfahren gemäss Anspruch 11, 12 oder 13, **dadurch gekennzeichnet, dass** die Strahlen durch Strahlführungselemente (8, 9a, 9b, 10) zu einem kombinierten Strahl zusammengeführt werden, wobei die Strahlfügungselemente (8, 9a, 9b) insbesondere einen Polteiler (8), einen dichroitische Spiegel (9a, 9b) und/oder ein Prismenteleskop (10) umfassen.

15. Verfahren gemäss einem der Ansprüche Anspruch 11 bis 14, **dadurch gekennzeichnet, dass** die Lichtstrahlen jeweils mit einer Kollimierlinse (7) kollimiert werden.

## Claims

1. Apparatus for producing a light beam having at least a first and a second light source (2, 3), in particular laser diodes, wherein the first and the second light source (2, 3) preferably emit light of the same wavelength during operation, **characterized in that** the light sources (2, 3) are arranged relative to one another such that the beam profile (11) of the first light source (2) is rotated with respect to the beam profile (12) of the second light source (3) about an axis (A) in the direction of the light propagation by a rotation angle (D), preferably by 90 degrees, and a beam rotation element (4) is arranged downstream of at least one of the light sources (2, 3), which beam rotation element (4) effects a rotation of the beam profile by an angle such that the beam profile (11, 12) of the light source (2, 3) after passing through the beam rotation element (4) is oriented in a plane perpendicular to the propagation direction (A) of the light substantially identically to the beam profile (11, 12) of the other light source (2, 3) in the plane perpendicular to the propagation direction, such that in particular the directions (13, 14) of the main axes of the beam profiles (11, 12) are parallel with respect to one another.

2. Apparatus according to Claim 1, **characterized in that** the apparatus comprises further light sources (5, 6), preferably two further light sources (5, 6), which during operation emit light having wavelengths that are respectively different to the wavelengths of the first and second light sources (2, 3).

3. Apparatus according to either of Claims 1 and 2, **characterized in that** beam guiding elements (8, 9a, 9b, 10) are provided, in particular in order to combine the light beams.

4. Apparatus according to one of the preceding claims, **characterized in that** light sources (2, 3, 5, 6) are provided, which during operation emit in each case polarized light, preferably linearly polarized light, wherein the polarization directions of the first and second light sources (2, 3) are rotated with respect to one another according to the beam profiles (11, 12), and the beam rotation element (4) does not effect the rotation of the polarization.

5. Apparatus according to one of the preceding claims, **characterized in that** each light source (2, 3, 5, 6) is assigned a collimating lens (7) for collimating a light beam which exits the light source (2, 3, 5, 6).

6. Apparatus according to one of Claims 3 to 5, **characterized in that** the beam guiding elements (8, 9a, 9b, 10) comprise a pole splitter (8).

7. Apparatus according to one of Claims 3 to 6, **characterized in that** the beam guiding elements (8, 9a, 9b, 10) comprise dichroic mirrors (9a, 9b).

8. Apparatus according to one of Claims 3 to 7, **characterized in that** the beam guiding elements (8, 9a, 9b, 10) comprise a prism telescope (10).

9. Apparatus according to one of the preceding claims, **characterized in that** a cylinder telescope is provided as the beam rotation element (4) and arranged such that the cylinder axis of which divides the rotation angle between the light sources, such that the cylinder axis is inclined with respect to a main axis of the beam profile of the light source in particular by 45 degrees.

10. Apparatus according to one of the preceding claims, **characterized in that** the light sources (2, 3, 5, 6) are arranged in a plane, preferably one next to the other, with further preference with an approximately parallel light propagation direction.

11. Method for producing a light beam, **characterized in that** at least two light sources (2, 3) emit light, preferably having the same wavelength, wherein the beam profile (11) of the light beam emitted by the first light source (2) is rotated with respect to the beam profile (12) of the light beam that is emitted by the second light source (3) by a rotation angle (D), preferably 90 degrees, and at least one of the light beams is guided through a beam rotation element (4), wherein the beam profile (11) of the light beam is rotated by an angle such that the beam profile (11) of the light source (2) after passing through the beam rotation element (4) is oriented in a plane perpendicular to the propagation direction (A) of the light substantially identically to the beam profile (12) of the other light source (3) in the plane perpendicular to the propagation direction (A), such that in particular the directions (13, 14) of the main axes of the beam profiles (11, 12) are parallel with respect to one another.

12. Method according to Claim 11, **characterized in that** preferably two, further light sources (5, 6) emit light, the wavelengths of which in each case differ from the wavelengths of the first and second light sources (2, 3).

13. Method according to Claim 11 or 12, **characterized in that** the light sources (2, 3, 5, 6) each emit polarized light, preferably linearly polarized light, wherein the polarization directions of the first and second light sources (2, 3) are rotated with respect to one another according to the beam profiles (11, 12), and the beam rotation element (4) does not effect the rotation of the polarization.

14. Method according to Claim 11, 12 or 13, **characterized in that** the beams are combined by beam guiding elements (8, 9a, 9b, 10) to form a combined beam, wherein the beam guiding elements (8, 9a, 9b) comprise in particular a pole splitter (8), a dichroic mirror (9a, 9b) and/or a prism telescope (10).

15. Method according to one of Claims 11 to 14, **characterized in that** the light beams are each collimated with a collimating lens (7).

## Revendications

1. Dispositif pour la production d'un faisceau de lumière comprenant au moins une première et une deuxième source de lumière (2, 3), en particulier des diodes laser, la première et la deuxième source de lumière (2, 3) émettant pendant le fonctionnement de préférence de la lumière de même longueur d'onde, **caractérisé en ce que**
les sources de lumière (2, 3) sont disposées l'une par rapport à l'autre de telle sorte que le profil de faisceau (11) de la première source de lumière (2), par rapport au profil de faisceau (12) de la deuxième source de lumière (3), soit tourné d'un angle de rotation (D), de préférence de 90°, autour d'un axe (A) dans la direction de propagation de la lumière et un élément de rotation de faisceau (4) est placé en aval d'au moins l'une des sources de lumière (2, 3), lequel provoque une rotation du profil de faisceau d'un certain angle de telle sorte que le profil de faisceau (11, 12) de la source de lumière (2, 3), après avoir traversé l'élément de rotation de faisceau (4), soit orienté dans un plan perpendiculairement à la direction de propagation (A) de la lumière de manière essentiellement identique au profil de faisceau (11, 12) de l'autre source de lumière (2, 3) dans le plan perpendiculaire à la direction de propagation, que les directions (13, 14) des axes principaux des profils de faisceau (11, 12) en particulier soient orientées parallèlement l'une à l'autre.

2. Dispositif selon la revendication 1, **caractérisé en ce que** le dispositif comprend des sources de lumière supplémentaires (5, 6), de préférence deux sources de lumière supplémentaires (5, 6), qui, pendant le fonctionnement, émettent de la lumière avec des longueurs d'ondes qui sont à chaque fois différentes des longueurs d'ondes de la première et de la deuxième source de lumière (2, 3).

3. Dispositif selon l'une quelconque des revendications 1 et 2, **caractérisé en ce que** des éléments de guidage de faisceau (8, 9a, 9b, 10) sont prévus, en particulier pour faire converger les faisceaux de lumière.

4. Dispositif selon l'une quelconque des revendications précédentes, **caractérisé en ce que** des sources de lumière (2, 3, 5, 6) sont prévues, lesquelles, pendant le fonctionnement, émettent chacune de la lumière polarisée, de préférence de la lumière polarisée linéairement, les directions de polarisation de la première et de la deuxième source de lumière (2, 3) étant tournées l'une par rapport à l'autre en fonction des profils de faisceau (11, 12) et l'élément de rotation de faisceau (4) ne provoquant pas la rotation de la polarisation.

5. Dispositif selon l'une quelconque des revendications précédentes, **caractérisé en ce qu'**à chaque source de lumière (2, 3, 5, 6) est associée une lentille de collimation (7) pour collimater un faisceau de lumière qui sort de la source de lumière (2, 3, 5, 6) .

6. Dispositif selon l'une quelconque des revendications 3 à 5, **caractérisé en ce que** les éléments de guidage de faisceau (8, 9a, 9b, 10) comprennent un diviseur de pôles (8).

7. Dispositif selon l'une quelconque des revendications 3 à 6, **caractérisé en ce que** les éléments de guidage de faisceau (8, 9a, 9b, 10) comprennent des miroirs dichroïques (9a, 9b).

8. Dispositif selon l'une quelconque des revendications 3 à 7, **caractérisé en ce que** les éléments de guidage de faisceau (8, 9a, 9b, 10) comprennent un télescope à prismes (10).

9. Dispositif selon l'une quelconque des revendications précédentes, **caractérisé en ce que** l'on prévoit en tant qu'élément de rotation de faisceau (4) un télescope cylindrique qui est disposé de telle sorte que son axe de cylindre divise l'angle de rotation entre les sources de lumière, l'axe de cylindre est en particulier incliné de 45° par rapport à un axe principal du profil de faisceau de la source de lumière.

10. Dispositif selon l'une quelconque des revendications précédentes, **caractérisé en ce que** les sources de lumière (2, 3, 5, 6) sont disposées dans un plan, de préférence l'une à côté de l'autre, plus préférablement avec une direction de propagation de la lumière approximativement parallèle.

11. Procédé pour générer un faisceau de lumière, **caractérisé en ce qu'**au moins deux sources de lumière (2, 3) émettent de la lumière, de préférence de même longueur d'onde, le profil de faisceau (11) du faisceau de lumière émis par la première source de lumière (2) étant tourné par rapport au profil de faisceau (12) du faisceau de lumière émis par la deuxième source de lumière (3) d'un angle de rotation (D), de préférence de 90°, et au moins l'un des faisceaux de lumière étant guidé par un élément de rotation de faisceau (4), le profil de faisceau (11) du faisceau de lumière étant tourné d'un certain angle de telle sorte que le profil de faisceau (11) de la source de lumière (2), après avoir traversé l'élément de rotation de faisceau (4), soit orienté dans un plan perpendiculairement à la direction de propagation (A) de la lumière essentiellement de manière identique au profil de faisceau (12) de l'autre source de lumière (3) dans le plan perpendiculaire à la direction de propagation (A), que les directions (13, 14) des axes principaux des profils de faisceau (11 12) en particulier soient parallèles l'une à l'autre.

12. Procédé selon la revendication 11, **caractérisé en ce que** de préférence deux sources de lumière supplémentaires (5, 6) émettent de la lumière dont les longueurs d'ondes sont à chaque fois différentes des longueurs d'ondes de la première et de la deuxième source de lumière (2, 3).

13. Procédé selon la revendication 11 ou 12, **caractérisé en ce que** les sources de lumière (2, 3, 5, 6) émettent chacune de la lumière polarisée, de préférence de la lumière polarisée linéairement, les directions de polarisation de la première et de la deuxième source de lumière (2, 3) étant tournées l'une par rapport à l'autre en fonction des profils de faisceau (11, 12) et l'élément de rotation de faisceau (4) ne provoquant pas la rotation de la polarisation.

14. Procédé selon la revendication 11, 12 ou 13, **caractérisé en ce que** les faisceaux sont réunis par des éléments de guidage de faisceau (8, 9a, 9b, 10) pour former un faisceau combiné, les éléments de guidage de faisceau (8, 9a, 9b) comprenant notamment un diviseur de pôles (8), un miroir dichroïque (9a, 9b) et/ou un télescope à prismes (10).

15. Procédé selon l'une quelconque des revendications 11 à 14, **caractérisé en ce que** les faisceaux de lumière sont à chaque fois collimatés avec une lentille de collimation (7).
